Europäisches Patentamt

European Patent Office

Office européen des brevets

(11) Publication number: **0 028 131**
A1

# EUROPEAN PATENT APPLICATION

(21) Application number: **80303755.5**

(22) Date of filing: **23.10.80**

(51) Int. Cl.³: **G 07 C 5/04,** G 07 C 5/10, G 04 G 1/00, H 03 K 17/687

(30) Priority: **25.10.79 GB 7937046**

(43) Date of publication of application: **06.05.81 Bulletin 81/18**

(84) Designated Contracting States: **BE DE FR IT SE**

(71) Applicant: **THE RANK ORGANISATION LIMITED, 11 Hill Street, London W1X 8AE (GB)**

(72) Inventor: **Papacharalambous, Stephen, 2 Spencer Court 17 Queen Anne's Place, Bush Hill Park Enfield Middlesex EN1 2PZ (GB)**

(74) Representative: **Cullis, Roger et al, c/o H.G. Amann Patents Manager The Rank Organisation Limited 439 Godstone Road, Whyteleafe, Surrey, CR3 OYG (GB)**

(54) **Electro-mechanical elapsed time recorder.**

(57)    An elapsed time recorder comprises electronic timing circuitry feeding electrical pulses to an operating coil (S) of an electro-mechanical counter. The recorder is arranged to be energised from a d.c. supply which may vary over a wide range of output voltage values. To accommodate such variations in supply voltage without requiring different operating coils, a low-power pulse generating stage (X1, I.C.1) of the timing circuitry is energised via a voltage regulator (R5,D2) such that the pulse generating stage (X1,I.C.1) outputs pulses of substantially constant magnitude independently of the d.c. supply voltage. These pulses are fed to a high-power driver stage formed by a power transistor T1 arranged to produce constant current pulses through the operating coil (S) independently of the supply voltage. Preferably the pulse generating stage includes a crystal oscillator (X1) to give temperature stability and accuracy.

## Electro-Mechanical Elapsed Time Recorder

The present invention relates to an electro-mechanical elapsed time recorder of the type arranged to be powered from various different external d.c. supplies of widely different nominal voltages, said recorder comprising d.c. supply terminals for connection to an external d.c. supply, an electro-mechanical counter, and timing circuitry arranged to supply electrical pulses to an operating coil of the counter at regular intervals, said timing circuitry including a high-power driver stage electrically connected in series with said operating coil across said d.c. supply terminals, and a low-power pulse generating stage arranged to supply pulses to said driver stage. As used herein in relation to the external d.c. supplies from which the recorder can be powered, the term "widely different nominal voltages" is intended to mean voltages ranging from a minimum value up to a maximum value which is several times said minimum value.

It is known to use recorders of the above-mentioned type for measuring vehicle running time. In such an application, a recorder may be required to run off a voltage lying anywhere between 6 v and 48 volts depending on the type of vehicle concerned. For the recorder to be able to cope with such a wide range of supply voltages, it has proved necessary to wind the driving solenoid of the counter with several coils, each appropriate for a particular part of the range of supply voltages from which the recorder may be required to operate. Not only is the provision of several coils an added expense in itself, but is also adds to the complexity of installation of the recorder and increases the risk of an error being made.

It is an object of the present invention to overcome these drawbacks of known elapsed time recorders of the above-mentioned type.

Accordingly, the present invention provides an electro-mechanical elapsed time recorder of the above type which is capable of being powered from said various different d.c. supplies without the need for internal circuitry changes, the timing circuitry further including a voltage regulator operative for all said various different d.c. supplies to regulate the voltage supplied to said pulse generating stage such that the magnitude of the pulses fed from that stage to the driver stage is substantially constant, and the said driver stage comprising a power transistor being arranged to convert said constant magnitude pulses fed thereto into constant current pulses through the operating coil of the counter.

The arrangement of the power transistor allows the recorder to be used with d.c. supplies of widely different nominal values without the need to change the operating coil of the electro-mechanical counter or to go to the expense of regulating the whole of the d.c. supply to the recorder. Preferably the pulse generating stage comprises a crystal oscillator and an electronic counter arranged to divide the oscillator output frequency. Advantageously, the electronic counter is a CMOS integrated circuit and the power transistor is a VMOS field effect transistor.

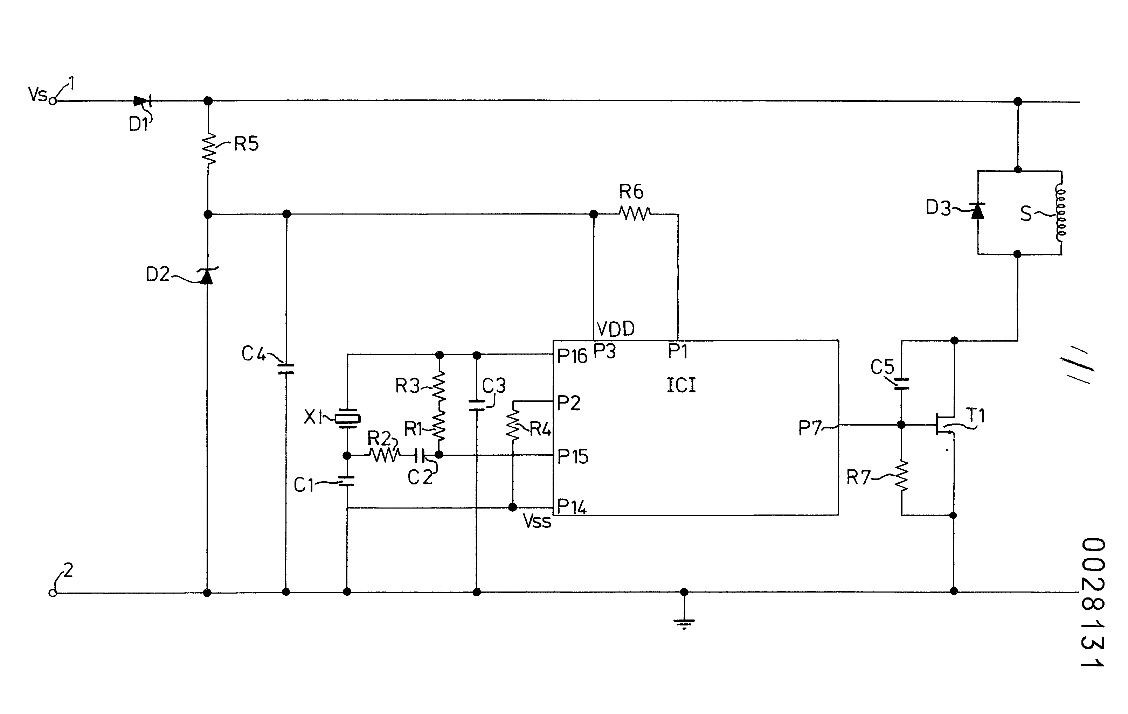

An elapsed time recorder embodying the invention will now be particularly described, by way of example, with reference to the accompanying drawing the sole Figure of which is a diagram of timing circuitry of the recorder.

The recorder to be described is arranged to

measure elapsed time in one hundredth of an hour intervals and comprises electronic timing circuitry producing regular timing pulses, and an electro-mechanical counter provided with a solenoid connected to receive said timing pulses and to increment the counter accordingly. Such electro-mechanical counters are well known and will not be further described hereinafter.

The timing circuitry of the recorder comprises four parts, namely a voltage regulator, a crystal oscillator, an electronic counter (divider), and a power driver for energising the solenoid of the electro-mechanical counter. The electronic counter is implemented by a CMOS integrated circuit I.C. 1 and the remaining parts of the timing circuitry are appropriately designed to interface with this integrated circuit I.C.1. In the present example the counter circuit I.C. 1 is a CD 4045BE integrated circuit providing a 21 stage counter. For convenience, the various connections to the circuit I.C. 1 will be referred to by the connection pin numbers of the CD 4045BE integrated circuit, prefixed by the letter "P".

The recorder is arranged to be energised via terminals 1 and 2 from a supply voltage Vs which may vary from +6 v to +48 volts, without requiring component value changes. The voltage regulator of the timing circuitry comprises a diode D1, a zener diode D2 and voltage-dropping resistor R5 connected in series between the positive supply rail and ground, and a capacitor C4 connected across the diode D2. Typically the zener voltage of diode D2 is 5.6 v and resistor R5 has a value of 1K with a rating of two watts. The supply inputs $V_{DD}$ and $V_{ss}$ of the integrated circuit I.C.1 (pins P3 and P14) are connected across the zener diode D2.

The crystal oscillator of the timing circuitry is a CMOS inverter oscillator utilising a crystal X1 and an amplifier provided by an input inverter of the integrated circuit I.C. 1 (this inverter being accessed via pins P15 and P16). The crystal X1 is connected in a pi-network (including resistors R1 and R3, and the capacitor C2) and operates at parallel resonance. A d.c. blocking capacitor C1 and a resistor R2 limit the voltage applied to the crystal X1 to a maximum of 1 volt peak to peak to prevent possible damage to the crystal. The frequency of oscillation of the crystal X1 is 58.25 KHz which, when divided down by the 21 stage counter circuit I.C. 1 provides an output pulse every 36 seconds (every one hundredth of an hour).

The calibration tolerance of the crystal X1 used is typically $\pm 0.05\%$ at $25^{\circ}$C and the frequency variation of the crystal over the operating temperature range is typically $-0.02\%$. To render the crystal oscillator less sensitive to voltage supply variations, the sources of the "p" and "n" transistors of the integrated circuit I.C.1 are connected to their respective substrates by source resistors R4 and R6 and pins P2 and P1.

The counter circuit I.C. 1 when implemented as a CD4045BE integrated circuit provides, in addition to 21 flip-flop counting stages, two flip-flops for sharing the output waveform for a 3.125% duty cycle. An output pulse is provided at pin P7 of the counter circuit I.C.1 every 36 seconds.

The power driver of the timing circuitry consists of a VMOS power field effect transistor T1 with a drain load provided by the solenoid S of the electro-mechanical counter of the recorder. A diode D3 is connected across the solenoid S. A resistor R7 and a capacitor C5 are respectively connected between the drain and source electrodes of transistor T1 and its gate electrode.

The transistor T1 provides a direct interface between the output of the CMOS integrated circuit I.C.1 and the solenoid S,  The transistor T1 is, for example, a VN67AF transistor which has a continuous drain current rating of 2 amps.

Since the transistor is a linear voltage controlled device (and is not operated in saturation), the drain-source current of the transistor is effectively controlled by the zener voltage of the diode D2 as it is this voltage which determines the output voltage from pin 7 of circuit I.C. 1 to the gate of transistor T1.  The driving current for solenoid S will thus be determined by the zener diode voltage independently of the actual supply voltage Vs.  As a result, a wide range of supply voltages can be accommodated without the need to use more than one coil for the solenoid S.

From the foregoing it can be seen that the timing circuitry is made up of a low-power pulse generating stage (formed by the oscillator and counter parts of the timing circuitry), and a high-power driver stage formed by the power transistor T1.  The arrangement of the transistor T1 is such that it is only necessary to regulate the supply of the low-power stage to enable substantially constant current pulses to be passed through the solenoid coil independent of the d.c. supply voltage.  As a consequence, the voltage regulator can be simple in form while still accommodating large variations in supply voltage.

Furthermore, due to the provision of the crystal oscillator and the dividing circuit I.C..1., the described recorder maintains accuracy of timing over wide variations in surrounding temperature.

Among other applications the described device can be used to measure the running time of vehicles such as lorries, buses, earth moving equipment, and battery driven vehicles.

CLAIMS

1. An electro-mechanical elapsed time recorder capable of being powered from various different external d.c. supplies of widely different nominal voltages, said recorder comprising d.c. supply terminals for connection to an external d.c. supply, an electro-mechanical counter, and timing circuitry arranged to supply electrical pulses to an operating coil of the counter at regular intervals, said timing circuitry including a high-power driver stage electrically connected in series with said operating coil across said d.c. supply terminals, and a low-power pulse generating stage arranged to supply pulses to said driver stage, characterised in that the recorder is capable of being powered from said various different d.c. supplies without the need for internal circuitry changes, the timing circuitry further including a voltage regulator operative for all said various different d.c. supplies to regulate the voltage supplied to said pulse generating stage such that the magnitude of the pulses fed from that stage to the driver stage is substantially constant, and the said driver stage comprising a power transistor being arranged to convert said constant magnitude pulses fed thereto into constant current pulses through the operating coil of the counter.

2. A recorder according to Claim 1, wherein said power transistor is a VMOS field effect transistor.

3. A recorder according to Claim 1, or Claim 2 in which said pulse generating stage comprises a crystal oscillator and an electronic counter arranged to divide the output frequency of the oscillator by a predetermined factor.

4. A recorder according to Claim 3, wherein the said oscillator is an inverter oscillator the crystal of which is connected in a pi-network and operates at parallel resonance.

5. A recorder according to Claim 4, in which said electronic counter is a CMOS integrated circuit and an input inverter of the integrated circuit is used as the inverting amplifying stage of the oscillator.

6. A recorder according to any one of the preceding claims, in which the pulse generating stage is arranged to output a pulse to the power transistor every 36 seconds.

7. A recorder according to Claim 6 when dependent on any one of Claims 3 to 5, in which the frequency of oscillation of said oscillator is 58.25 KHz and said electronic counter is a 21 stage counter.

0028131

Vs

D1

R5

D3

S

C5

T1

R7

D2

C4

R6

X1

R2

R3

R1

C2

C1

C3

R4

VDD  P3  P16  P2  P15  P14

P1  IC1

P7

Vss

| **DOCUMENTS CONSIDERED TO BE RELEVANT** | | | **CLASSIFICATION OF THE APPLICATION (Int. Cl.³)** |
|---|---|---|---|
| Category | Citation of document with indication, where appropriate, of relevant passages | Relevant to claim | |
| | US - A - 4 083 052 (METCALF)<br><br>* Figure 6; column 12, line 30 - column 13, line 35 *<br><br>-- | 1,3,4 | G 07 C  5/04<br>              5/10<br>G 04 G  1/00<br>H 03 K  17/687 |
| | US - A - 3 948 039 (LEVERAUS)<br><br>* Figure 1; column 2, line 13 - column 4, line 15 *<br><br>-- | 1 | |
| | FR - A - 2 372 465 (SOPECO-SAIA, AG)<br><br>* Figures; page 1, line 33 - page 3, line 22 *<br><br>-- | 1-3,5 | **TECHNICAL FIELDS SEARCHED (Int. Cl.³)**<br><br>G 07 C  5/04<br>              5/10<br>G 04 F  8/00<br>G 04 G  1/00<br>G 04 C  3/14<br>H 03 K  17/687<br>              17/64<br>              17/284<br>G 05 F  3/20 |
| | US - A - 3 854 281 (REICHERT)<br><br>* Figure 2; column 3, line 17 - column 4, line 43 *<br><br>-- | 1 | |
| | FR - A - 2 074 913 (HAMILTON WATCH COMPANY)<br><br>* Figures 1,2,5,6; page 1, line 35 - page 8, line 26 *<br><br>-- | 1-3 | |
| | US - A - 4 117 353 (BUTLER et al.)<br><br>* Figure 1; column 2, line 6 - column 3, line 61 *<br><br>-- | 1 | **CATEGORY OF CITED DOCUMENTS**<br><br>X: particularly relevant<br>A: technological background<br>O: non-written disclosure<br>P: intermediate document<br>T: theory or principle underlying the invention<br>E: conflicting application<br>D: document cited in the application<br>L: citation for other reasons |
| | GB - A - 979 964 (RCA)<br><br>* Figures 1,2; page 2, line 25 - page 3, line 41 *<br><br>-- ./. | 1 | |
| The present search report has been drawn up for all claims | | | &: member of the same patent family, corresponding document |

| Place of search | Date of completion of the search | Examiner |
|---|---|---|
| The Hague | 02-02-1981 | FEUER |

EPO Form 1503.1   06.78

European Patent
Office

EUROPEAN SEARCH REPORT

0028131

Application number

EP 80 30 3755
-2-

## DOCUMENTS CONSIDERED TO BE RELEVANT

| Category | Citation of document with indication, where appropriate, of relevant passages | Relevant to claim |
|---|---|---|
| | CH - A - 570 077 (SCHEINHUTTE) <br> * Figures; column 1, line 1 - column 2, line 1 * <br><br> -- <br><br> DE - A - 2 431 006 (RHODE & SCHWARZ) <br> * Figures 1,2; page 2, line 27 - page 4, line 21 * <br><br> ---- | 1 <br><br><br><br><br> 1 |

CLASSIFICATION OF THE APPLICATION (Int. Cl. ³)

TECHNICAL FIELDS SEARCHED (Int. Cl. ³)